Europäisches Patentamt

**European Patent Office**

Office européen des brevets

(19)

(11) Veröffentlichungsnummer: **0 021 370**
**B1**

(12) **EUROPÄISCHE PATENTSCHRIFT**

(45) Veröffentlichungstag der Patentschrift:
**23.03.83**

(51) Int. Cl.³: **G 01 R 21/00,** G 07 F 17/00

(21) Anmeldenummer: **80103469.5**

(22) Anmeldetag: **21.06.80**

(54) **Verrechnungsgerät für elektrische Energie.**

(30) Priorität: **28.06.79 DE 2926067**

(43) Veröffentlichungstag der Anmeldung:
**07.01.81 Patentblatt 81/1**

(45) Bekanntmachung des Hinweises auf die Patenterteilung:
**23.03.83 Patentblatt 83/12**

(84) Benannte Vertragsstaaten:
**CH FR GB LI**

(56) Entgegenhaltungen:
**CH-A-454 241**
**DE-A-2 433 239**
**DE-A-2 641 806**
**DE-A-2 746 432**
**US-A-4 184 580**

(73) Patentinhaber: **Licentia Patent-Verwaltungs-GmbH,**
**Theodor-Stern-Kai 1, D-6000 Frankfurt/Main 70 (DE)**

(72) Erfinder: **Weippert, Wolfgang, Ing. grad,**
**Magnolienweg 2, D-3250 Hameln 1 (DE)**
Erfinder: **Szimkat, Hans-Joachim, Steinweg 4,**
**D-3256 Coppenbrügge 4 (DE)**

(74) Vertreter: **Langer, Karl-Heinz, Dipl.-Ing. et al, Licentia**
**Patent-Verwaltungs-GmbH Theodor-Stern-Kai 1,**
**D-6000 Frankfurt/Main 70 (DE)**

BUNDESDRUCKEREI BERLIN

## Verrechnungsgerät für elektrische Energie

Die Erfindung betrifft ein Verrechnungsgerät für elektrische Energie, die in Übergabestationen an einen Speicher eines Elektrofahrzeuges abgegeben wird und bei dem mit Hilfe eines Elektrizitätszählers eine der abgegebenen Energiemenge proportionale, in einem Impulszähler registrierte zeitliche Folge von Verrechnungsimpulsen erzeugt wird, mit einer integrierten Kontrolleinheit, die einerseits mit einer Vergleicherstufe zur Überwachung zweier in einem Doppelimpulsgeber des Elektrizitätszählers erzeugten und in einer Bewertungsstufe auf einen Impuls pro Währungseinheit umgewichteten Impulsfolgen gleicher Frequenz zusammenwirkt, und die andererseits zur Überwachung des nachgeschalteten Verrechnungsaußenkreises unter Einbeziehung des Ladegerätes dient.

Ein derartiges Verrechnungsgerät ist in der DE-OS 2 641 806 beschrieben. Hierbei werden allerdings die von einem Impulserzeuger gelieferten Verrechnungsimpulse direkt einem Impulszähler zugeführt, so daß eine fehlerhafte Impulsübertragung nicht bemerkt wird. Das bekannte Verrechnungsgerät hat außerdem keine sinnvoll realisierbare Einstellmöglichkeit des Verrechnungs-Tarifgefüges.

Es ist Aufgabe der Erfindung, das vorerwähnte Verrechnungsgerät so auszubilden, daß es an die regionalen Gegebenheiten anpaßbar ist und die bei dem Gerät verwendete Schaltungsanordnung größte Sicherheit für einwandfreie Übertragung der Meßwerte liefert.

Erfindungsgemäß wird diese Aufgabe dadurch gelöst, daß die Bewertungsstufe aus einer Reihenschaltung eines $N_1/N_2$-Teilers als Vorteiler, der zur Basisanpassung der Mengenerfassung dient und bei welchem Zähler und Nenner einen bestimmten Wertebereich der natürlichen Zahlen durchlaufen können, und eines programmierbaren 100 : x-Teilers besteht, welcher als Impulsraten-Multiplizierer (Rate Multiplier) geschaltet und vorzugsweise dekadisch derart einstellbar ist, daß die Ausgangsimpulsfolge die Einheitswertigkeit von einem Impuls je Währungseinheit hat und daß die Kontrolle des Verrechnungsaußenkreises durch eine ständig getaktete Widerstandsmessung in der Weise erfolgt, daß die Wirksamkeit der Messung jeweils in den Zählimpulspausen durchgreift, wobei die Zählimpulse über eine mit einem Taktgenerator zusammenwirkende Synchronisierstufe zu dem einen von zwei Eingängen eines UND-Gliedes geführt sind, dessen entkoppelter Ausgang mit im Elektrofahrzeug vorgesehenen Zählrelais verbindbar ist und über einen Ruhestrom-Widerstand an Betriebsspannung liegt sowie mit dem Eingang eines Fenster-Diskriminators in Verbindung steht, dessen Ausgang auf den D-Eingang eines D-Flip-Flops wirkt, dessen Takteingang vom Taktgenerator beeinflußt wird, wobei der Ausgang des Flip-Flops über ein Negationsglied auf den zweiten Eingang des UND-Gliedes wirkt.

Aus der DE-OS 2 433 239 ist bereits eine elektronische Impulsfolgen-Summiereinrichtung bekannt, bei der unmittelbar hinter Eingangsstufen Impulswertanpassungsstufen vorgesehen sind, welche die Summandenimpulse im Verhältnis $N_1/N_2$ umwichten. Diese Anpassungsstufen gestatten es nicht, die umzuwandelnden Wertigkeiten dekadisch umzuwandeln.

Anhand der Zeichnung sei die Erfindung an einem Ausführungsbeispiel näher erläutert.

Fig. 1 zeigt das Blockschaltbild des Verrechnungsgerätes, während in

Fig. 2 das Schaltbild für die Kontrolle des Verrechnungsaußenkreises wiedergegeben ist.

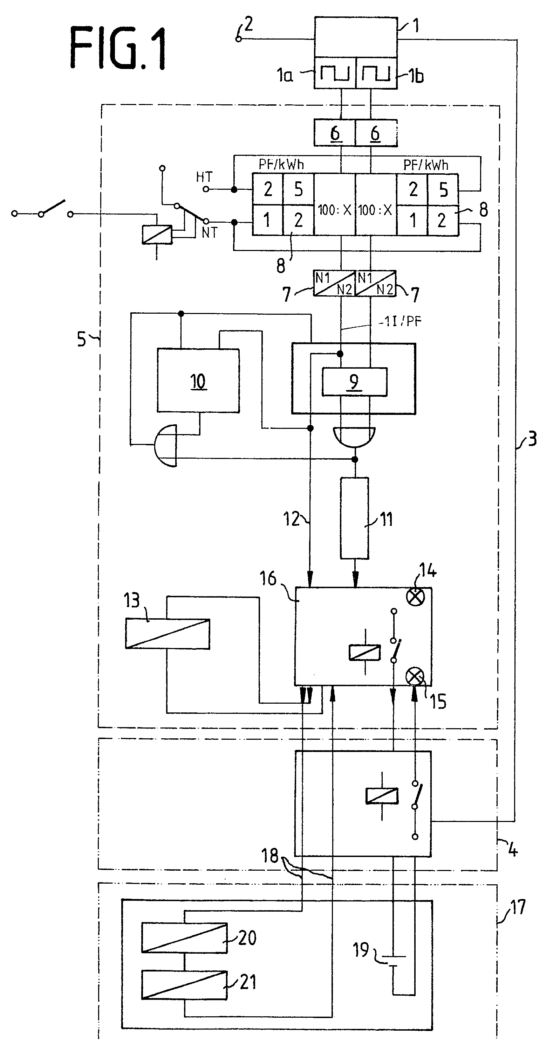

Bei der Anordnung nach Fig. 1 ist ein Elektrizitätszähler 1 mit zwei Impulsgebern 1a und 1b vorgesehen, der über eine Leitung 2 einerseits mit einem Versorgungsnetz und über eine Leitung 3 mit einem Ladegerät 4 in Verbindung steht. Die Impulsgeber, die in Abhängigkeit von der mit dem Elektrizitätszähler gemessenen verbrauchten Energie gleichartige Impulsfolgen liefern, sind mit Eingangsstufen 6 des eigentlichen Verrechnungsgerätes 5 verbunden. Die Eingangsstufen 6 enthalten über Optokoppler angebundene Verknüpfungsnetzwerke, die eine Anpassung an unterschiedliche Impulsgabe-Einrichtungen nach Impulsart und Impulspegel erlauben. Eine den Eingangsstufen nachgeschaltete Bewertungsstufe enthält für jede Impulsspur einen $N_1/N_2$-Teiler 7, der zur Basisanpassung der Mengenerfassung dient und bei dem Zähler und Nenner einen bestimmten Wertebereich der natürlichen Zahlen durchlaufen können. In Reihe mit diesem Teiler 7 liegt in jeder Impulsspur ein weiterer 100 : x-Teiler 8. Mit Hilfe der Teiler 7 ist eine Umwichtung der von den Eingangsstufen kommenden Impulse auf Pfennig pro kWh möglich, während mit Hilfe der Teiler 8 die abgegebenen Zählimpulse so gewichtet werden, daß ein Impuls einem Pfennig entspricht. Bei den Teilern 7 ist die Vorwahl nach Hochtarif HT oder Niedertarif NT getrennt möglich. Die Teiler sind zweistellig dekadisch einstellbar. Den Teilern ist eine Vergleicherstufe nachgeschaltet, die aus einer Differenzstufe 9, einem Teilernetzwerk 10 und einer Verzögerungsvorwahlstufe 11 besteht. Die Differenzstufe 9 wirkt als Schieberegister mit einer Schrittbreite von mehreren Impulseinheiten. Die Schrittbreite ist einstellbar und beim Ausführungsbeispiel für fünf Impulseinheiten ausgelegt. Der dritte Schritt stellt die Richtposition dar, die nach oben und nach unten jeweils um maximal zwei Schritte verlassen werden kann, ohne daß am Ausgang der Differenzstufe ein Signal erscheint. Die Richtposition bleibt im zeitlichen Mittel erhalten, wenn über beide Impulsspuren die gleiche Anzahl von Impulsen einlaufen. Das Teilernetzwerk 10, das von der einen Impulsspur beaufschlagt wird, wirkt in der Weise auf die Differenzstufe, daß es nach einer bestimmten Impulszahl (beim Ausführungsbeispiel nach 200 Impulsen) die Differenzstufe auf die Richtposition zurückstellt, falls eine Abweichung hiervon vorliegen sollte. Die mögliche Pendlung von ±2 Impulseinheiten in der Differenzstufe entspricht einem Registrierfehler von ±1%, bezogen auf die im Fehlerfall verbrauchten Arbeitseinheiten. Die Verzögerungsvorwahlstufe 11 gestattet die Verschiebung einer Fehlermeldung um mehrere Fehlererfassungszyklen des Teilernetzwerkes 10. Die Verschiebung der Fehlermeldung ist an der Verzögerungsvorwahlstufe einstellbar. Über die Leitung 12, von der auch die Impulse für das Teilernetzwerk 10 abgenommen werden, greifen die Impulse zu einem Gesamtverbrauchszählwerk 13 durch. Das Gesamtverbrauchszählwerk 13 ist an eine Abschalt- und Fehlermeldestufe 16 angeschlossen, die u. a. Signallampen 14 und 15 enthält. Das Fehlerereignis »Bewertungsschaltung oder Impulsgeber gestört« wird mit Hilfe der Signallampe 14 registriert, während die Signallampe 15 die Störung des Ladestromkreises anzeigt. Ist die Bewertungsschaltung oder der Impulsgeber gestört, so erfolgt zugleich mit der Anzeige über die Signallampe 14 die Ausgabe eines externen Ladestopp-Signals an das Ladegerät 4, wobei gleichzeitig die Verrechnungszählung statisch unterbunden wird. Der über eine Kuppelverbindung 18 zu einem Elektrofahrzeug 17 geführte Verrechnungszählkreis wird ebenfalls über die Abschalt- und Fehlermeldestufe 16 geführt. Auch im Elektrofahrzeug, dessen Batterie 19 an das Ladegerät angeschlossen wird, sind Zählwerke zur Erfassung der Verbrauchswerte vorgesehen. Es ist ein Zählwerk 20 zur Registrierung des Einzelladungsverbrauchs und ein weiteres Zählwerk 21 zur Registrierung des Gesamtverbrauchs vorgesehen.

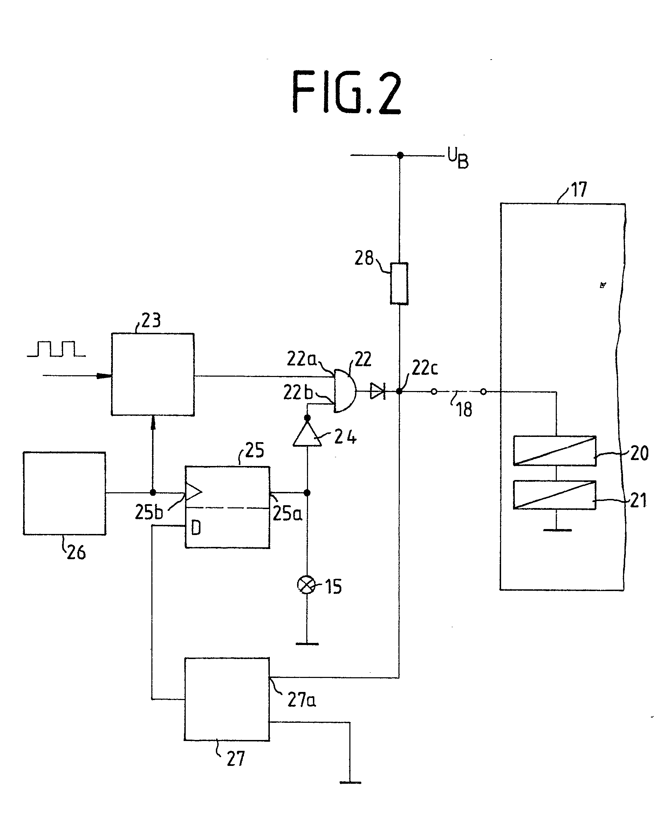

Der Verrechnungszählkreis wird während des Ladevorganges dauernd auf Unterbrechung und Kurzschluß geprüft. Die Kontrolle des Verrechnungsaußenkreises erfolgt durch eine ständig getaktete Widerstandsmessung mit einer Schaltung gemäß Fig. 2. Hierbei werden an den Ausgang 22c eines UND-Gliedes 22 über die Kuppelverbindung 18 die Zählwerke 20 und 21 des Elektrofahrzeuges 17 angeschlossen. Die vom Impulsgeber kommenden und entsprechend gewichteten Zählimpulse gelangen über eine Synchronisierstufe 23 an den einen Eingang 22a des UND-Gliedes 22. Der andere Eingang 22b wird über ein Negierungsglied 24 vom Ausgang 25a eines D-Flip-Flops 25 beeinflußt. An den Takteingang 25b des D-Flip-Flops liegt ein Taktgenerator 26, der auch auf die Synchronisierstufe 23 wirkt. Der D-Eingang des D-Flip-Flops liegt am Ausgang eines Fenster-Diskriminators 27, dessen Eingang 27a mit dem Ausgang 22c des UND-Gliedes 22 in Verbindung steht. Der Ausgang des UND-Gliedes liegt außerdem über einen Ruhewiderstand 28 an Betriebsspannung U$_B$. Eine Störungslampe 29 ist vom Ausgang 25a des D-Flip-Flops gegen Masse geschaltet. Der Widerstand 28 ist so gewählt, daß bei eingeschalteter Kuppelverbindung 18 die am Fensterdiskriminator anstehende Spannung an diesem kein Ausgangssignal auslöst. Der D-Eingang des D-Flip-Flops hat also L-Signal. Die Frequenz des Taktgenerators 26 ist größer als die der in die Synchronisierstufe einlaufenden Zählimpulse. Die Synchronisierstufe sorgt dafür, daß jeder einlaufende Zählimpuls erst in der auf einen Taktimpuls folgenden Pause der Taktimpulsfolge herausgegeben wird. Da der Eingang 22b des UND-Gliedes 22 H-Signal führt, können die Zählimpulse durchgreifen und über die Kuppelverbindung 18 zu den Zählwerken 20 und 21 gelangen. Die Spannungserhöhung am Eingang 27a beim Auftreten eines Zählimpulses ruft zwar am Ausgang des Fensterdiskriminators ein H-Signal hervor, jedoch bewirkt dieses am D-Flip-Flop keine Änderung des Signals am Ausgang 25a, da dieses mit einer am Takteingang 25b anstehenden Impulspause der Taktimpulsfolge zusammenfällt.

Bei unterbrochener Kuppelverbindung 18 ruft die am Eingang 27a des Fensterdiskriminators 27 anstehende Spannung ein H-Signal an dessen Ausgang hervor, das jetzt länger am D-Eingang des D-Flip-Flops wirksam ist, so daß der nächste Taktimpuls des Taktgenerators das am D-Eingang anstehende H-Signal zum Ausgang durchschiebt und somit am Eingang 22b des UND-Gliedes 22 ein L-Signal erzeugt. Das H-Signal am Ausgang 25a des D-Flip-Flops bringt die Störungslampe 29 zum Leuchten und unterbricht die weitere Impulszählung. Auch jede andere länger andauernde Spannungsveränderung am Eingang 27a des Fensterdiskriminators bewirkt das Aufleuchten der Signallampe 15, so daß auch bei eingeschalteter Kuppelverbindung 18 Störungen über die Signallampe 15 angezeigt werden und die Impulsübertragung unterbleibt. Die Abschaltung des Ladegerätes kann dann dadurch erfolgen, daß das am Ausgang 25a des D-Flip-Flops auftretende H-Signal zur Erregung eines Abschaltrelais ausgenutzt wird.

## Patentansprüche

1. Verrechnungsgerät für elektrische Energie, die in Übergabestationen an einen Speicher (19) eines Elektrofahrzeuges (17) abgegeben wird, und bei dem mit Hilfe eines Elektrizitätszählers (1) eine der abgegebenen Energiemenge proportionale, in einem Impulszähler registrierte zeitliche Folge von Verrechnungsimpulsen erzeugt wird, mit einer integrierten Kontrolleinheit, die einerseits mit einer Vergleicherstufe (9, 10, 11) zur Überwachung zweier in einem Doppelimpulsgeber (1a, 1b) des Elektrizitätszählers (1) erzeugten und in einer Bewertungsstufe (7, 8) auf einen Impuls pro Währungseinheit umgewichteten Impulsfolgen gleicher Frequenz zusammenwirkt und die andererseits zur Überwachung des nachgeschalteten Verrechnungsaußenkreises unter Einbeziehung des Ladegerätes (4) dient, dadurch gekennzeichnet, daß die Bewertungsstufe aus einer Reihenschaltung eines $N_1/N_2$-Teilers (7) als Vorteiler, der zur Basisanpassung der Mengenerfassung dient und bei welchem Zähler und Nenner einen bestimmten Wertebereich der natürlichen Zahlen durchlaufen können, und eines programmierbaren 100 : x-Teilers (8) besteht, welcher als Impulsraten-Multiplizierer (Rate Multiplier) geschaltet und vorzugsweise dekadisch derart einstellbar ist, daß die Ausgangsimpulsfolge die Einheitswertigkeit von einem Impuls je Währungseinheit hat, und daß die Kontrolle des Verrechnungsaußenkreises durch eine ständig getaktete Widerstandsmessung in der Weise erfolgt, daß die Wirksamkeit der Messung jeweils in den Zählimpulspausen durchgreift, wobei die Zählimpulse über eine mit einem Taktgenerator (26) zusammenwirkende Synchronisierstufe (23) zu dem einen (22a) von zwei Eingängen (22a, 22b) eines UND-Gliedes (22) geführt sind, dessen entkoppelter Ausgang (22c) mit im Elektrofahrzeug (17) vorgesehenen Zählrelais (20, 21) verbindbar ist und über einen Ruhestrom-Widerstand (28) an Betriebsspannung ($U_B$) liegt, sowie mit dem Eingang (27a) eines Fensterdiskriminators (27) in Verbindung steht, dessen Ausgang auf den D-Eingang eines D-Flip-Flops (25) wirkt, dessen Takteingang (25b) vom Taktgenerator beeinflußt wird, wobei der Ausgang (25a) des Flip-Flops über ein Negationsglied auf den zweiten Eingang (22b) des UND-Gliedes (22) wirkt.

2. Verrechnungsgerät nach Anspruch 1, dadurch gekennzeichnet, daß die Vergleicherstufe (9, 10, 11) aus einer als Schieberegister wirkenden Differenzstufe (9) für die beiden Impulsfolgen besteht, die durch einen mit den Impulsen der einen Impulsspur beaufschlagten Teiler (10) bei vorgegebener Impulszahl rückstellbar ist und die auf eine Verzögerungsvorwahlstufe (11) für eine Abschalt- und Fehlermeldestufe (16) wirkt.

3. Verrechnungsgerät nach Anspruch 1 und 2, dadurch gekennzeichnet, daß der 100 : x-Teiler (8) vorzugsweise durch ein entsprechendes Gehäusefenster von außen oder ferneinstellbar ist.

4. Verrechnungsgerät nach Anspruch 1 bis 3, dadurch gekennzeichnet, daß eine an eine Inkasso-Anordnung angebundene Entwerterschaltung vorgesehen ist mit einem auf Null zurückzählenden Zählwerk, das bei Nullstellung die Sperrung der Ladung durch Erzeugung eines entsprechenden Pegels an einem dritten Eingang des UND-Gliedes bewirkt.

## Claims

1. Pricing apparatus for electrical energy supplied to a store (19) of an electrically propelled vehicle (17) at transfer stations, in which, with the aid of an electricity meter (1), a sequence of pricing pulses proportional to the quantity of electricity supplied is registered in a pulse counter, having an integral control unit which firstly cooperates with a comparator stage (9, 10, 11) to monitor two pulse sequences of the same frequency which are produced in a double pulse generator (1a, 1b) of the electricity meter (1) and which are re-weighted in an evaluation stage (7, 8) to give one pulse per monetary unit, and which secondly serves to monitor the connected external pricing circuit taking account of the charging device (4), characterised in that the evaluation stage comprises a series connection of an $N_1/N_2$ divider (7) as predivider, which serves for determining the measurement base and in which the numerator and denominator can run through a specific range of natural numbers, and a programmable 100 : x divider (8), the later being connected as a rate multiplier and being preferably settable decadically so that the output pulses have a value equivalent to one pulse per monetary unit, and that the external pricing circuit is controlled by a continuously pulsed impedance measurement so that the effect of the measurement in each case appears in the gaps between the counting pulses, the latter being fed, via a synchronising stage (23) operating in conjunction with a clock pulse generator (26), to one (22a) of two inputs (22a, 22b) of an AND-gate (22), wherein the decoupled output (22c) of the latter is connectible to the operating voltage ($U_B$) via a steady-state-current-impedence (28), and also is connected to the input (27a) of a window discriminator (27) of which the output is applied to the D-input of a D-bistable (25), the clock input (25b) thereof being acted upon by the clock generator and the output (25a) acting via an inverter member on the second input (22b) of the AND-gate (22).

2. Pricing apparatus as in claim 1, characterised in that the comparator stage (9, 10, 11) comprises a difference stage (9) for the two pulse sequences, which can be re-set at a pre-determined pulse count by a divider (10) supplied with the pulses of one sequence, and which acts on a delay pre-selector stage (11) for a switch-off and error-signal stage (16).

3. Pricing apparatus as in claim 1 and 2, characterised in that the 100 : x divider (8) can be, preferably through an opening in the housing, externally or remotely set.

4. Pricing apparatus as in claims 1 to 3, characterised in that a cancellation circuit, with a counter mechanism which counts back to zero, and connected to a charge collection device, is provided which when set to zero blocks charging by producing a suitable voltage level at a third input of the AND-gate.

## Revendication

1. Appareil de tarification pour énergie électrique fournie par des postes d'alimentation à un accumulateur (19) d'un véhicule électrique (17) et dans lequel est créé à l'aide d'un compteur électrique (1) une succesion chronologique d'impulsions de tarification enregistrée par un compteur d'impulsions et proportionelle à la quantité d'énergie délivrée, cet appareil comportant une unité de contrôle intégrée qui, d'une part, coopère avec un étage comparateur (9, 10, 11) destiné à la surveillance de deux trains d'impulsions de même fréquence créés par un générateur d'impulsions double (1a, 1b) du compteur électrique (1) et convertis pour former une impulsion par unité monétaire et qui, d'autre part, sert, en combinaison avec le chargeur de batterie (4), à la surveillance du circuit de tarification séparé et branché à la suite, caractérisé en ce que l'étage d'évaluation est composé d'un branchement en série d'un diviseur (7) $N_1/N_2$ en tant que diviseur préliminaire, qui sert à l'adaptation de base de la détection quantitative et dans lequel le numérateur et le dénominateur peuvent parcourir une échelle de valeurs déterminée des chiffres naturels et d'un diviseur programmable (8) de 100 : x qui est connecté en tant que multiplicateur des taux d'impulsions (multiplicateur de taux) et qui peut être réglé de préférence par décades, en ce le train d'impulsions de sortie représente pour une impulsion la valeur de base d'une unité monétaire et en ce que le contrôle du circuit de tarification séparé s'effectue à l'aide de mesures périodiques de la résistance de façon que la mesure s'effectue à chaque fois pendant les intervalles d'impulsions, les impulsions de comptage étant alors appliquées par l'intermédiaire d'un étage de synchronisation (23) coopérant avec un générateur d'horloge (26), à l'une (22a) de deux entrées (22a, 22b) d'un élément ET (22) dont la sortie découplée (22c) pouvant être reliée avec un relais compteur (20, 21) prévu sur le véhicule électrique (17) est raccodé, d'une part, à la tension de service ($U_B$) par l'intermédiaire d'une résistance à courant de repos (28) et, d'autre part, à l'entrée (27a) d'un discriminateur à fenêtre (27) dont la sortie agit sur l'entrée D d'une bascule D bistable (25) dont l'entrée d'horloge (25b) est influencée par le générateur d'horloge et dont la sortie (25a) agit sur la deuxième (22b) de l'élément ET (22) par l'intermédiaire d'un élément de négation.

2. Appareil de tarification suivant la revendication 1, caractérisé en ce que l'étage comparateur (9, 10, 11) est constitué par un étage différentiateur (9) qui agit à la manière d'un registre à décalage sur les deux trains d'impulsions qui, lors d'un nombre d'impulsions prédéterminé, peut être remis à zéro à l'aide d'un diviseur (10) recevant les impulsions de l'une des pistes d'impulsions et qui agit sur un étage de présélection de la temporisation (11) pour un étage d'arrêt et de signalisation de perturbations (16).

3. Appareil de tarification suivant l'une des revendications 1 et 2, caractérisé en ce que le diviseur (8) de 100 : x peut être réglé de l'extérieur grâce à une fenêtre prévue dans le boîtier ou par une commande à distance.

4. Appareil de tarification suivant l'une des revendications 1 à 3, caractérisé en ce qu'il comporte un circuit de comptage à retour relié à un dispositif de facturation et comprenant un compteur comptant en arrière jusqu'à zéro et qui commande, lors de sa position zéro, l'arrêt de la charge en créant un niveau approprié à la troisième entrée de l'élément ET.

# FIG.1

# FIG.2